# EUROPÄISCHE PATENTSCHRIFT

(11) **EP 2 316 143 B1**
(45) Veröffentlichungstag und Bekanntmachung des Hinweises auf die Patenterteilung: **03.05.2017**
(21) Anmeldenummer: 09778591.9
(22) Anmeldetag: 17.09.2009
(51) Int. Cl.: H01L 51/52, H01L 51/44

(54) **OLED-STRUKTUR UND EIN VERFAHREN ZUR HERSTELLUNG EINER OLED-STRUKTUR**
OLED AND METHOD FOR PRODUCING AN OLED
DIODE ÉLECTROLUMINESCENTE ORGANIQUE (DELO) ET PROCÉDÉ DE PRODUCTION D'UNE DELO

(30) Priorität: 26.09.2008 DE 102008049057
(43) Veröffentlichungstag der Anmeldung: 04.05.2011
(73) Patentinhaber: Fraunhofer-Gesellschaft zur Förderung der angewandten Forschung e.V., 80686 München (DE)
(72) Erfinder: AMELUNG, Joerg, 01099 Dresden (DE)
(74) Vertreter: Schenk, Markus
(86) Internationale Anmeldenummer: PCT/EP2009/006736
(87) Internationale Veröffentlichungsnummer: WO 2010/034431

(56) Entgegenhaltungen:
- EP-A1- 2 144 290
- EP-A2- 1 536 491
- EP-A2- 1 970 960
- WO-A1-2008/077615
- WO-A2-2004/057674
- US-A1- 2005 170 551
- US-A1- 2008 008 887

## Beschreibung

Ausführungsbeispiele der vorliegenden Erfindung beziehen sich auf eine OLED-Struktur und ein Verfahren zur Herstellung einer OLED-Struktur. Weitere Ausführungsbeispiele umfassen eine Herstellung großflächiger Bauelemente mittels einer organischen Leuchtdiodenstruktur (OLED = organische lichtemittierende Diode). Als flächiger Leuchtkörper mit gegenüber einer herkömmlichen lichtemittierenden Diode (LED) moderater Leuchtdichte ist die OLED ideal geeignet für eine Herstellung flächiger diffuser Lichtquellen. Damit können auf der Basis organischer Leuchtdioden (OLED) neuartige Flächenlichtelemente verwirklicht werden. Diese Lichtquellen sind sehr viel versprechend und ihnen wird eine ähnliche Entwicklung vorhergesagt, wie der der OLED basierenden Displays (Anzeigen). Durch die verwendete Dünnschichttechnologie wird es in Zukunft ferner möglich werden, OLEDs auch als flexible Leuchtkörper zu realisieren, die ganz neue Anwendungen in der Beleuchtung von Räumen gestatten.

Da OLEDs stromgetriebene Bauelemente darstellen, ist eine homogene Stromdichteverteilung auf großen Flächen ein wichtiger Punkt bei der Herstellung großflächiger Leuchtelemente. Inhomogenitäten in der Stromdichteverteilung entlang der großflächigen Leuchtelemente wären nämlich sofort in Leuchtstärkenschwankungen sichtbar und deshalb bedarf es einer entsprechenden homogenen Stromeinspeisung, um eine gleichmäßig flächige Leuchtdichte zu erreichen.

Da die Lichterzeugung in einer organischen Schichtanordnung erfolgt, die zwischen zwei Elektroden angeordnet ist, bedarf es zumindest einer transparenten Elektrode, so dass das Licht die OLED verlassen kann. Der transparente Kontakt wird normalerweise durch ein transparent leitfähiges Oxid (TCO) oder mittels durchsichtiger Metallschichten realisiert, wobei die TCO-Schicht oder die durchsichtige Metallschicht häufig eine geringe Leitfähigkeit aufweisen. Somit limitiert der transparente Kontakt die Homogenität der Stromdichteverteilung und somit die maximale Leuchtflächengröße. Große Leuchtflächen wären anderenfalls nur mit großen Verlusten und der damit verbundenen Wärmeentwicklung möglich, was im Allgemeinen nicht akzeptabel ist.

Ein ähnliches Problem stellt sich ebenfalls bei Solarzellen auf der Basis organischer Materialien, die in ihrem Aufbau der OLED sehr ähnlich sind. Aufgrund der verwendeten organischen Materialien ermöglichen diese Strukturen allerdings eine Umwandlung optischer Strahlung in elektrischen Strom, wobei dieser Strom über die Kontakte abgeleitet wird. Auch hier vermindert der transparente elektrische Kontakt, den das einfallende Licht überwindet, die maximal nutzbare Bauelementgröße.

Um trotzdem größere Flächen (große OLEDs) zu erreichen, werden beispielsweise Metallverstärkungen in Form von Netzen (Metallgrids) in die beispielhafte TCO-Schicht eingebracht. Diese Metallgrids (auch Busbars genannt) verringern den effektiven Schichtwiderstand entsprechend deren Belegungsdichte und ermöglichen somit eine Realisierung größerer Diodenflächen. Aufgrund der Nichttransparenz dieser Metallgrids verringert sich jedoch die effektive Leuchtfläche. Aus diesem Grunde sind Metallgrids nur bis ca. 25 % der TCO-Fläche überhaupt sinnvoll. Eine sinnvolle Verbesserung wäre die Erhöhung der Gridmetalldicke, was aber aufgrund der Strukturierungsmöglichkeiten und der Schichtdicken der organischen Schichtdicken nicht sinnvoll ist. Zu diesem Nachteil kommt weiterhin hinzu, dass die metallverstärkte ITO-Schicht nur an den Außenkanten kontaktiert wird, was trotz der effektiven Widerstandsverringerung die maximale Leuchtelementfläche limitiert.

OLEDs sind wie bereits erwähnt stromgetriebene Bauelemente, so dass zur Erreichung einer Mindestleuchtstärke ein Mindeststrom erforderlich ist, der möglichst gleichmäßig durch jeden OLED-Abschnitt zu führen ist. Um den Gesamtstrom gleichzeitig zu limitieren, ist eine Parallelschaltung von OLED-Elementen ungünstig. Besser ist dagegen eine Serienschaltung, wie sie beispielsweise für konventionelle OLED-Strukturen in US 7 307 278, US 7 034 470 und US 6 693 296 offenbart wurden. Außerdem wurde in DE 102007004509 A1 eine Verbesserung der Homogenität durch eine zweite Metallisierungsebene mit einer dicken Metalllage, die die transparente Kontaktschicht niederohmig kontaktiert, erreicht. Diese zweite Metallisierungsebene ermöglicht dabei einen niederohmigen Kontakt und somit die Herstellung großflächiger Lichtelemente. Die besagte zweite Metallisierungsebene wird dabei auf der undurchsichtigen OLED-Elektrode (erste Metallisierungsebene) angeordnet. Eine elektrische Isolierung der zweiten Metallisierungsebene von der ersten Metallisierungsebene wird durch eine Isolationsschicht erreicht. Diese Isolationsschicht wird in Teilbereichen durch offene Stellen (so genannte Vias) unterbrochen, durch welche der Kontakt zur transparenten (höherohmigen) Schicht erreicht wird.

Die Nachteile der konventionellen OLED-Strukturen umfassen somit eine inhomogene Stromdichteverteilung oder die durch Metallgrids hervorgerufene Verringerung der Leuchtausbeute. Weitere Nachteile sind sichtbare Übergangsbereiche bei einer Serienverschaltung von OLED-Elementen oder bei einer Parallelschaltung die erforderlichen hohen Stromdichten.

Die US 2008008887 beschreibt eine organische, Licht emittierende Vorrichtung und ein Verfahren zum Herstellen derselben. Das Verfahren weist folgende Schritte auf: Bilden einer ersten Komponente, die zumindest ein erstes Material auf einem ersten Substrat aufweist; Bilden einer zweiten Komponente, die zumindest ein zweites Material auf einem zweiten Substrat aufweist, wobei zumindest eine Öffnung durch die zweite Komponente gebildet ist; Bilden einer dritten Komponente; und Laminieren der ersten Komponente, der zweiten Komponente und der dritten Komponente derart miteinander, dass die zweite Komponente zwischen der ersten Komponente und der dritten Komponente angeordnet ist, wobei das zumindest eine erste Material und das zumindest eine zweite Material zumindest einen Teil einer organischen, elektro-optischen Vorrichtung bilden, die zwischen dem ersten Substrat und dem zweiten Substrat angeordnet ist, wobei die dritte Komponente mit der zweiten Komponente gebondet ist, und die dritte Komponente mit der ersten Komponente gebondet ist, durch die zumindest eine Öffnung.

Die EP 1536491 (A2) beschreibt ein organisches Elektrolumineszenzelement, das (1) ein Substrat (2), eine erste Elektrode (3), eine organische Schicht (4), eine zweite Elektrode (5), ein Abdichtbauglied (6), einen ersten Anschluss (7) und ein Durchgangsloch (10) auf weist. Die erste Elektrode ist auf das Substrat geschichtet. Die organische Schicht, die eine Licht emittierende Schicht umfasst, ist auf die erste Elektrode geschichtet. Die zweite Elektrode ist auf die organische Schicht geschichtet. Das Abdichtbauglied deckt die zweite Elektrode teilweise ab. Ein Abschnitt der zweiten Elektrode, der nicht durch das Abdichtbauglied abgedeckt ist, funktioniert als ein zweiter Anschluss (9). Der erste Anschluss (7) ist auf dem Abdichtbauglied (6) auf einer Seite gegenüberliegend zu der zweiten Elektrode (5) vorgesehen. Das Durchgangsloch (10) erstreckt sich durch das Abdichtbauglied, die zweite Elektrode und die organische Schicht und wird zum Verbinden der ersten Elektrode (3) und des ersten Anschlusses (7) verwendet. Die erste Elektrode und die zweite Elektrode sind elektrisch mit einer Leistungsquelle verbunden.

Ausgehend von diesem Stand der Technik liegt der vorliegenden Erfindung die Aufgabe zugrunde, eine OLED-Struktur bereitzustellen, die bei einer geringen Gesamtstromdichte ein homogenes großflächiges Leuchtfeld ermöglicht.

Diese Aufgabe wird durch eine OLED-Struktur nach Anspruch 1 und ein Verfahren zur Herstellung derselben nach Anspruch 10 gelöst.

Der Kerngedanke der vorliegenden Erfindung besteht zum einen in der Nutzung einer zweiten Metallisierungsschicht (Kontaktschicht) für ein organisches opto-elektrisches Bauelement, wobei die Kontaktschicht von der ersten (undurchsichtigen) Metallisierungsschicht durch eine Isolationsschicht getrennt ist, um die Grundelektrode (transparente Elektrode) zu kontaktieren und außerdem über Durchkontaktierungen oder Kontaktelementen eine Serienverschaltung von mehreren optisch aktiven Bereichen zu ermöglichen. Optional kann die Isolationsschicht ferner dazu genutzt werden, um eine Verkapselung für die organische Schichtstruktur bereitzustellen, so dass sich ein großflächiges kompaktes Leuchtelement bildet, in welchem die einzelnen optisch aktiven Bereiche so nahe aneinander gebracht werden können, dass keine Übergänge sichtbar sind und eine homogene Stromeinspeisung durch alle Flächenelemente ermöglicht wird.

Beispiele für organische opto-elektrische Bauelemente umfassen beispielsweise eine OLED oder eine OLED-Struktur. Ein Standardaufbau einer OLED weist als Grundelektrode beispielsweise eine transparente ITO-Schicht (ITO = Indium-Zinn-Oxid) auf. Auf die transparente ITO-Schicht wird dann beispielsweise eine organische Schicht oder einer organische Schichtanordnung, die teilweise bis zu sieben Sublagen aufweisen kann, aufgebracht. Abschließend wird eine metallische Kathode (erste Metallisierungsschicht oder Deckelektrode) ausgebildet. Da bei konventionellen Kontakten die ITO-Schicht nur am Rand des Leuchtelements kontaktiert wird, führt bei großflächigen Leuchtelementen wie gesagt der hochohmige Widerstand der ITO-Schicht zu einer Inhomogenität der Stromeinspeisung. Durch diese konventionelle Vorgehensweise wird die maximale Größe einer gleichmäßig leuchtenden OLED auf ca. 50 x 50 mm² limitiert.

Die erwähnte Kontaktierung am Rand des Leuchtelements, welche zu der besagten Limitierung führt, hat auch noch folgenden Hintergrund. Die OLED ist häufig mit einer weiteren Glasschicht versehen, die eine Aussparung für ein Trocknungsmittel aufweist und bezwecken soll, dass die OLED vor dem Sauerstoff und der Feuchtigkeit der Luft geschützt ist. Aus diesem Grund sind die Kontakte der OLED am Rand der Elemente ausgebildet. Dadurch wird allerdings eine nahtfreie Kombination mehrerer OLED-Elemente zu einer großen Gesamtfläche verhindert, da immer Abstände zwischen den Elementen existieren, die optisch sichtbar sind oder mit zusätzlichen Diffusern verdeckt werden müssen.

Ausführungsbeispiele umfassen somit eine OLED-Struktur mit einem Schichtstapel, der eine Grundelektrode, eine organische Schichtanordnung, eine Deckelektrode, eine Isolationsschicht und eine Kontaktschicht aufweist. Die organische Schichtanordnung ist dabei zwischen der Grundelektrode und der Deckelektrode angeordnet, und die Deckelektrode ist zwischen der organischen Schichtanordnung und der Kontaktschicht angeordnet. Die Deckelektrode und die Grundelektrode sind so strukturiert, dass mehrere lateral benachbarte optisch aktive Bereiche gebildet sind. Die Grundelektrode, die organische Schichtanordnung, die Deckelektrode und die Kontaktschicht sind dabei über Durchkontaktierungen derart verschaltet, dass zumindest zwei optisch aktive Bereiche so in Serie geschaltet sind, dass ein Stromfluss durch die zumindest zwei optisch aktive Bereiche in einer gleichen Richtung zwischen der Grundelektrode und der Deckelektrode weist, und dass der Stromfluss zwischen den zumindest zwei optisch aktiven Bereichen durch die Kontaktschicht verläuft, und dass ferner die Kontaktschicht und die Grundelektrode lateral in einem Inneren der zwei optisch aktive Bereiche kontaktiert. Es wird also ein erster optisch aktiver Bereich durch einen ersten Teil der Grundelektrode und einen ersten Teil der Deckelektrode, die beidseitig die organische Schichtanordnung kontaktieren, gebildet. Weiterhin wird ein zweiter optisch aktiver Bereich durch einen zweiten Teil der Grundelektrode und einen zweiten Teil der Deckelektrode, die die organische Schichtanordnung beidseitig kontaktieren, gebildet, wobei ein lateraler Abstand (D) zwischen dem ersten optisch aktiven Bereich und dem zweiten optisch aktiven Bereich existiert. Die Isolationsschicht ist teilweise zwischen der Kontaktschicht und der Deckelektrode angeordnet, so dass innerhalb des zweiten optisch aktiven Bereichs die jeweilige Kontaktschicht von der jeweiligen Deckelektrode elektrisch isoliert ist, wobei die Kontaktschicht so strukturiert ist, dass ein erster und ein zweiter Teil gebildet ist. Die organische Schichtanordnung weist komplementär dotierte organische Schichten, die einen pn-Übergang bilden, auf. Optional weist das organische opto-elektrische Bauelement ferner beispielsweise Glas als ein Substrat auf, auf welches die Grundelektrode angeordnet wird. Die optisch aktiven Bereiche sind dabei durch jene lateralen Bereiche definiert, in denen die organische Schichtanordnung durch die Grund- und Deckelektrode beidseitig kontaktiert ist, so dass in diesen Bereichen eine Lichterzeugung bei einem entsprechenden Stromfluss möglich ist. Ferner können die einzelnen optisch aktiven Bereiche derart dicht aneinander angeordnet werden, dass optisch kein Übergang zwischen den einzelnen optisch aktiven Bereichen sichtbar ist. Ein dadurch entstehendes OLED-Flächenleuchtelement kann homogenes Licht erzeugen. Die Durchkontaktierungen der Kontaktschicht zu der Grundelektrode können beispielsweise das gleiche Material aufweisen wie die zweite Metallisierungsschicht (beispielsweise ein niederohmiges Metall). Es ist außerdem vorteilhaft, wenn die Kontaktierung der Grundelektrode lediglich von einer dem Substrat abgewandten Seite der Grundelektrode erfolgt. Dadurch kann erreicht werden, dass die Durchkontaktierungen (Kontaktelemente) von der Substratseite her nicht sichtbar sind. Optional weist die Deckelektrode ebenfalls ein Metall auf, welches derart strukturiert wird, dass es in einem inneren Bereich Öffnungen aufweist, durch die die Durchkontaktierungen der Kontaktschicht geführt werden, wobei ebenfalls in den so erhaltenen Öffnungen die Isolationsschicht ausgebildet wird, so dass eine Isolierung zwischen der Kontaktschicht/den Durchkontaktierungen und der Deckelektrode erreicht wird.

Optional können pro optisch aktiven Bereich ebenfalls mehrere Durchkontaktierungen ausgebildet werden, so dass die Grundelektrode beispielsweise punktweise an verschiedenen Punkten kontaktiert wird, wodurch eine weitere Erhöhung der Homogenität der Stromdichte und somit der Leuchtdichte erreicht wird. Außerdem kann optional die Kontaktierung der Deckelektrode durch weitere Durchkontaktierungen, die zwischen der Kontaktschicht und der Deckelektrode ausgebildet sind, oder durch eine Kontaktierung entlang eines Streifens geschehen. Die Kontaktierung der Kontaktschicht als auch die Kontaktierung der Deckelektrode kann über einen Randbereich des großflächigen organischen opto-elektrischen Bauelements geschehen. Die Schichtdicke der Kontaktschicht kann außerdem derart gewählt werden, dass der Flächenwiderstand der Kontaktschicht niederohmig ist bzw. einen vorgegebenen Schwellwert nicht überschreitet.

Bei der vorgeschlagenen Kontaktierungsart ist der Anschlusswiderstand somit nicht mehr durch die transparente Elektrode, sondern lediglich durch den Flächenwiderstand der Kontaktschicht (zweite Metallisierungsebene) definiert. Durch die Verwendung einer hohen Schichtdicke (beispielsweise in Form einer dicken Schicht oder einer massiven Metallplatte) kann zum einen der Anschlusswiderstand verringert werden und zum anderen ergibt sich die Möglichkeit, die Schicht als Verkapselung des Systems zu nutzen. Dadurch ist eine direkte Kontaktierung des Leuchtelements von der Metallseite her möglich, da keine zusätzliche Passivierung oder Verkapselung erforderlich ist. Eine randfreie Montage der OLED-Segmente ist somit möglich.

Die Verwendung der Serienverschaltung der Diode (optisch aktiven Bereichen) ermöglicht ebenfalls eine Verringerung des Gesamtstroms und gleichzeitig eine Vergrößerung der Leuchtfläche. Damit kann für einen vorgegebenen Gesamtstrom eine größere Leuchtfläche realisiert werden, als dies bei konventionellen OLED-Elementen möglich wäre. Gemäß Ausführungsbeispielen wird somit die Herstellung von großformatigen OLED-Leuchtelementen und die Herstellung serienverschalteter OLED-Leuchtelemente möglich.

Ausführungsbeispiele der vorliegenden Erfindung verändern somit konventionelle Kontaktierungsarten derart, dass auch ein zweiter (nachtteiliger) Effekt - nämlich die erhöhte Stromdichte - als Resultat der herkömmlichen OLED-Herstellung verbessert wird. Optional können die optisch aktiven Bereiche verschieden ausgestaltet sein, so dass beispielsweise rechteckige oder sechseckige Ausführungsformen möglich sind, die mosaikförmig einen großflächigen Leuchtkörper bilden.
Weitere Ausführungsbeispiele umfassen ebenfalls ein Verfahren zur Herstellung eines organischen opto-elektrischen Bauelements. Bei dem erfindungsgemäßen Verfahren werden auf dem Substrat die Grundelektroden ausgebildet und strukturiert, so dass die Grundelektrode mehrere Teile aufweist, die variabel gestaltet sein können. Auf die Teile der Grundelektrode erfolgt die Abscheidung der organischen Schichtanordnung in einem weiteren Prozessschritt. Daran anschließend erfolgt die Abscheidung der Deckelektrode, wobei dieser Prozessschritt ebenfalls eine Strukturierung umfassen kann. In dem Prozess der Strukturierung werden die äußeren Abmaße der optisch aktiven Bereiche definiert und außerdem werden Öffnungen ausgebildet, durch die die Durchkontaktierungen zwischen der Kontaktschicht und der Grundelektrode geführt werden. Nach der Strukturierung der Deckelektroden wird eine isolierende Zwischenschicht (Isolierschicht) ausgebildet, die ebenfalls Öffnungen und weitere Öffnungen aufweist, wobei die Öffnungen der späteren Kontaktierung zwischen der Kontaktschicht und der Grundelektrode dienen und die weiteren Öffnungen der späteren Kontaktierung zwischen der Kontaktschicht und der Deckelektrode dienen.

Die Strukturierungen können beispielsweise einen Ätzschritt (z. B. ein Plasmaätzen) und die Nutzung einer Schattenmaske umfassen. Alternativ kann die Zwischenschicht auch in-situ unter Verwendung einer weiteren Schattenmaske strukturiert werden. Daran anschließend erfolgt die Abscheidung und Strukturierung der Kontaktschicht, die durch die Öffnungen die Grundelektroden kontaktiert (z.B. mittels der Durchkontaktierungen). Dieser Kontaktschicht hat eine bessere Leitfähigkeit als die Grundelektrode und reduziert somit den Leitungswiderstand der Grundelektrode ohne die Transparenz der Grundelektrode einzuschränken (wie dies bei der Verwendung eines Metallgrids der Fall ist). Weiterhin kontaktiert die Kontaktschicht durch die weiteren Öffnungen über weitere Durchkontaktierungen die Deckelektrode, so dass eine integrierte Reihenschaltung ausgebildet wird.

Durch die verschachtelte Verdrahtung erzeugt das System eine Serienschaltung von zumindest zwei Dioden (optisch aktive Bereiche) mit einer minimalen Beeinflussung der aktiven Fläche der OLED. Die minimale Beeinflussung wird dadurch erreicht, dass die Durchkontaktierung (zwischen Kontaktschicht und Grundelektrode) zur Serienschaltung in den nicht sichtbaren Bereich der OLED/Solarzelle gelegt wird.

Bevorzugte Ausführungsbeispiele der vorliegenden Erfindung werden nachfolgend Bezug nehmend auf die beiliegenden Zeichnungen näher erläutert. Es zeigen:
- Fig. 1: eine Querschnittsansicht durch eine OLED-Struktur nach Ausführungsbeispielen der vorliegenden Erfindung;
- Fig. 2: eine Draufsicht auf ein Leuchtelement mit rechteckförmig ausgestalteten optisch aktiven Bereichen; und
- Fig. 3: eine Draufsicht auf ein großflächiges Leuchtelement mit sechseckförmig ausgestalteten optisch aktiven Bereichen.

Bevor im Folgenden die vorliegende Erfindung anhand der Zeichnungen näher erläutert wird, wird darauf hingewiesen, dass gleiche Elemente in den Figuren mit den gleichen oder ähnlichen Bezugszeichen versehen sind, und dass eine wiederholte Beschreibung dieser Elemente weg gelassen wird.

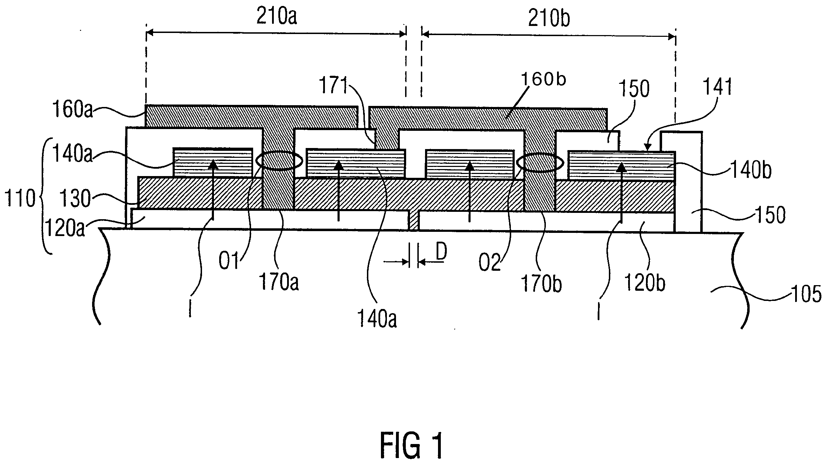

Fig. 1 zeigt ein Ausführungsbeispiel für eine OLED-Struktur gemäß Ausführungsbeispielen.

Die gezeigte OLED-Struktur weist ein Substrat 105 auf, auf welchem eine Grundelektrode 120 ausgebildet ist. Die Grundelektrode 120 weist bei dem gezeigten Ausführungsbeispiel einen ersten Teil 120a und einen zweiten Teil 120b auf, die entlang eines Spaltes mit einer Breite D voneinander getrennt sind. Auf die Grundelektrode 120 ist eine organische Schichtanordnung 130 ausgebildet, auf welcher eine Deckelektrode 140 angeordnet ist. Die Deckelektrode 140 weist (ebenso wie die Grundelektrode 120) einen ersten Teil 140a und einen zweiten Teil 140b auf, die ebenfalls voneinander getrennt (elektrisch isoliert) sind. Ferner weist das Ausführungsbeispiel eine Kontaktschicht 160 mit einem ersten Teil 160a und einem zweiten Teil 160b auf, die von der Deckelektrode 140 durch eine Isolationsschicht 150 elektrisch isoliert ist.

Der erste Teil der Kontaktschicht 160a ist über eine erste Durchkontaktierung 170a mit dem ersten Teil der Grundelektrode 120a elektrisch verbunden und der zweite Teil der Kontaktschicht 160b ist über eine zweite Durchkontaktierung 170b mit dem zweiten Teil der Grundelektrode 120b elektrisch verbunden. Ferner ist der zweite Teil der Kontaktschicht 160b über eine weitere Durchkontaktierung 171 mit dem ersten Teil der Deckelektrode 140a elektrisch verbunden. Die erste Durchkontaktierung 170a ist dabei durch eine erste Öffnung O1 des ersten Teils der Deckelektrode 140a und der organischen Schichtanordnung 130 hindurch ausgebildet, wobei die erste Öffnung O1 des ersten Teils der Deckelektrode 140a derart ausgebildet ist, dass innerhalb der ersten Öffnung O1 ebenfalls die Isolationsschicht 150 eine Isolierung zwischen dem ersten Teil der Deckelektrode 140a und der ersten Durchkontaktierung 170a gewährleistet. Ebenso ist der zweite Teil der Kontaktschicht 160b über eine zweite Öffnung 02 des zweiten Teils der Deckelektrode 140b und der organischen Schichtanordnung 130 mit dem zweiten Teil der Grundelektrode 120b elektrisch verbunden, wobei wiederum innerhalb der zweiten Öffnung 02 des zweiten Teils der Deckelektrode 140b die Isolationsschicht 150 derart ausgebildet ist, dass die zweite Durchkontaktierung 170b von dem zweiten Teil der Deckelektrode 140b elektrisch isoliert ist. Die Durchkontaktierungen 170, die die Grundelektrode 120 von der dem Substrat 105 abgewandeten Seite her kontaktieren, sind von der Substratseite her nicht sichtbar.

Der erste Teil der Grundelektrode 120a und der erste Teil der Deckelektrode 140a sind dabei derart strukturiert, dass sie einen ersten optisch aktiven Bereich 210a definieren, und zwar über den lateralen Bereich, über welchen die organische Schichtanordnung 130 von dem ersten Teil der Grundelektrode 120a und dem ersten Teil der Deckelektrode 140a beidseitig kontaktiert wird. Ebenso ist ein zweiter optisch aktiver Bereich 210b durch jene Fläche definiert, über welche die organische Schichtanordnung 130 durch den zweiten Teil der Grundelektrode 120b und den zweiten Teil der Deckelektrode 140b beidseitig kontaktiert wird.

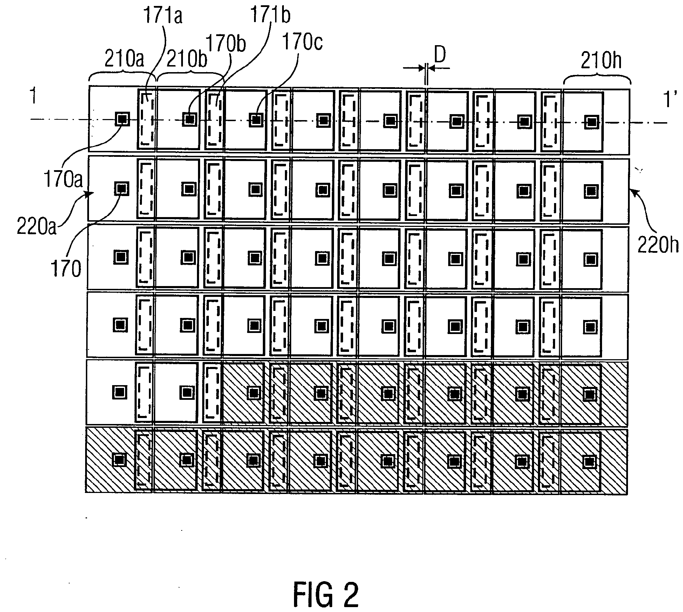

Bei der Querschnittsansicht der Fig. 1 ist zu beachten, dass die Öffnungen O1, O2, in denen die erste und zweite Durchkontaktierung 170a,b ausgebildet sind, lediglich Öffnungen innerhalb des ersten Teils der Deckelektrode 140a und des zweiten Teils der Deckelektrode 140b bilden. Dies bedeutet, dass der erste Teil der Deckelektrode 140a in der gezeigten Querschnittsansicht zwar aus zwei Teilen besteht - beide Teile jedoch miteinander verbunden sind (in der Richtung senkrecht zur Zeichenebene). Ebenso weist der zweite Teil der Deckelektrode 140b in der gezeigten Querschnittsansicht zwei Teile auf, die jedoch elektrisch miteinander verbunden sind; siehe auch Fig. 2.

Während des Betriebes des Bauelements kommt somit ein Stromfluss I zustande, der stets in eine Richtung zwischen der Grundelektrode 120 und der Deckelektrode 140 verläuft. Wenn beispielsweise ein Strom I in dem ersten Teil der Kontaktschicht 160a eingespeist wird, verläuft der Stromfluss entlang der ersten Durchkontaktierung 170a in den ersten Teil der Grundelektrode 120a und von dort nach Passieren der organischen Schichtanordnung 130 zum ersten Teil der Deckelektrode 140a. Der Strom I wird dann über die weitere Durchkontaktierung 171 in den zweiten Teil der Deckelektrode 140b geleitet und von dort über die zweite Durchkontaktierung 170b in den zweiten Teil der Grundelektrode 120b weitergeleitet. Von hier aus passiert der Strom I wiederum die organische Schichtanordnung 130 in Richtung des zweiten Teils der Deckelektrode 140b, von wo aus der Strom I an einem Kontaktpad (Anschlusskontakt) 141 abgegriffen wird. Bei jedem Passieren der organischen Schichtanordnung 130 wird bei einer OLED dabei ein Teil der Energie in Licht umgewandelt.

Die Lichtabstrahlung der OLED-Struktur, wie sie in der Fig. 1 gezeigt ist, erfolgt durch das Substrat 105, welches beispielsweise ein Glas aufweist, und die Strukturierung der Grundelektrode 120 und der Deckelektrode 140 ist beispielsweise derart gewählt, dass der laterale Abstand D zwischen dem ersten optisch aktiven Bereich 210a und dem zweiten optisch aktive Bereich 210b so klein gewählt ist, dass optisch keine Grenze zwischen den benachbarten optisch aktiven Bereichen 210a,b sichtbar ist. Dies bedeutet, dass der Abstand D einerseits groß genug gewählt ist, um eine elektrische Isolierung des ersten und zweiten Teils der Grundelektrode 120a, b zu gewährleisten, jedoch klein genug ist, um eine erkennbare Randstruktur zwischen den optisch aktiven Bereichen nicht sichtbar zu machen und dadurch eine homogen strahlende Leuchtfläche entsteht. Um beispielsweise zu verhindern, dass ein Stromfluss zwischen dem ersten Teil der Grundelektrode 120a und dem zweiten Teil Deckelektrode 140b oder umgekehrt zwischen dem zweiten Teil der Grundelektrode 120b und ersten Teil der Deckelektrode 120a zustande kommt, kann es vorteilhaft sein, die laterale Ausdehnung des jeweiligen Teils der Deckelektrode 140a oder 140b kleiner zu wählen als die laterale Ausdehnung des jeweiligen Teils der Grundelektrode 120a oder 120b, so dass die Grundelektrode 120 die Deckelektrode 140 lateral überragt.

Die in der Fig. 1 gezeigte Ausführung zeigt lediglich zwei optisch aktive Bereiche 210, wobei jedoch die gezeigte Struktur entsprechend fortgesetzt werden kann, so dass sich die serielle Schaltung beispielsweise über die gesamte Breite eines OLED-Leuchtelements erstreckt. Die Kontaktierung der Deckelektrode 140 kann dann seitlich durch das Kontaktpad 141 erfolgen, wobei das Kontaktpad 141 durch eine Ausnehmung in der Isolationsschicht 150 gebildet ist, so dass die Deckelektrode 140 dort kontaktierbar ist. Ferner kann ebenfalls die Kontaktschicht 160 entlang des Randbereichs kontaktiert werden.

Bei dem in der Fig. 1 gezeigten Ausführungsbeispiel dient die Isolierschicht 150 ferner dazu, eine Passivierung für den Schichtstapel 110, der durch die Grundelektrode 120, die organische Schichtstruktur 130 und die Deckelektrode 140 gebildet wird, bereitzustellen, so dass sowohl die organische Schichtanordnung 130 als auch die Grundelektrode 120 vollständig von einer Umgebung (und insbesondere seitlich) geschützt werden. Die so erhaltene Verkapselung (Isolationsebene) kann optional eine Dünnschichtverkapselung für die organische Schicht 130 darstellen, so dass die Prozessierung der Kontaktschicht 160 nicht unter Stickstoff oder in Vakuum durchgeführt zu werden braucht.

Die Fig. 2 zeigt eine Draufsicht auf ein großflächiges Leuchtelement, welches eine Vielzahl von optisch aktiven Bereichen 210, 220, ... aufweist, wobei die Draufsicht von der dem Substrat 105 abgewandten Seite dargestellt ist. Die Querschnittsansicht der Fig. 1 bezieht sich beispielsweise auf die eingezeichnete Querschnittslinie 1-1'.

In einer ersten Reihe sind dabei acht in Serie geschaltete optisch aktive Bereiche 210a, 210b, ..., 210h dargestellt, die sich jeweils in dem Abstand D voneinander befinden und die Nummerierung von links nach rechts vorgenommen wurde. In einer zweiten Reihe sind wiederum acht in Serie geschaltete optisch aktive Bereiche 220a, ..., 220h dargestellt. Die flächige Anordnung wiederholt sich dann in einer dritten, vierten bis hin zu einer sechsten Reihe. Je nach der gewünschten Leuchtfläche kann die Anzahl der optisch aktiven Bereiche 210, 220, ... verschieden gewählt werden, so dass die gezeigte 6 x 8-Anordnung lediglich ein Ausschnitt aus einem großflächigen Leuchtelement darstellt. In der gezeigten Draufsicht erscheint die Kontaktschicht 160 rechteckförmig und weist eine Überlappung zwischen zwei benachbarte optisch aktive Bereiche auf, so dass beispielsweise eine Verbindung zwischen der Durchkontaktierung 170b und der weiteren Durchkontaktierung 171a hergestellt wird und sich eine Reiherverschaltung der optisch aktiven Bereiche 210, 220, ... ergibt. Der erste Teil der Kontaktschicht 160a ist allerdings in der Draufsicht der Fig. 2 nicht dargestellt. Da jedoch die Darstellung der Fig. 2 lediglich einen Ausschnitt darstellt, ist das entsprechende Verschaltungsmuster weiter fortzusetzen. Alternativ kann die erste Durchkontaktierung 170a auch als eine Randkontaktierung für die serielle Verschaltung genutzt werden.

Wie aus der Draufsicht der Fig. 2 ersichtlich ist, sind die Durchkontaktierungen 170a,b,... nahezu zentral (mittig) und somit lateral im Inneren der optisch aktiven Bereiche 210, 220, ... angeordnet. Die weiteren Durchkontaktierungen 171 weisen jeweils eine längliche Form auf, so dass sie sich nahezu über die gesamte seitliche Ausdehnung (die Richtung senkrecht zur Zeichenebene der Fig. 1) der Kontaktschicht 160 erstrecken.

Bei weiteren Ausführungsbeispielen können pro optisch aktive Bereich 210, 220, ... mehrere Durchkontaktierungen 170 ausgebildet sein, so dass jeder der optisch aktiven Bereich 210 möglichst gleichförmig mit einem elektrischen Strom durchsetzbar ist. Ebenso können die weiteren Durchkontaktierungen 171 andere Formen aufweisen bzw. mehrere nebeneinander angeordnete Bereiche aufweisen (in der Richtung senkrecht zur Zeichenebene der Fig. 1). Es ist ebenfalls ersichtlich, dass die Deckelektrode 140 sich um die Durchkontaktierung 170 herum erstreckt, so dass ein möglichst großer optisch aktive Bereich und somit eine möglichst große lichtabgebende Fläche entsteht.

Die in der Fig. 2 gezeigte Darstellung in Form von viereckförmig ausgebildeten oder quadratisch ausgebildeten optisch aktiven Bereichen ist jedoch lediglich ein Beispiel, wobei die optisch aktiven Bereiche bei weiteren Ausführungsbeispielen andere Formen aufweisen können, wobei sich wiederum mosaikförmig das großflächige Leuchtelement (Leuchtmodul) gebildet wird.

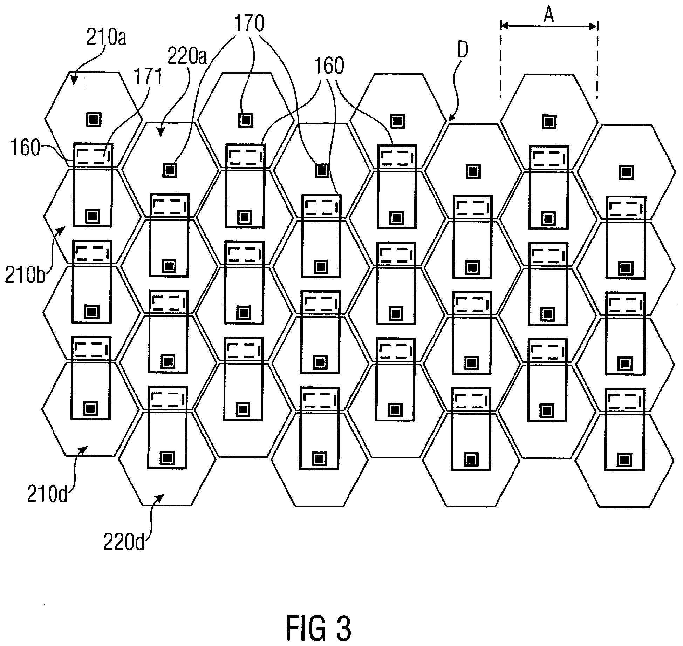

Die Fig. 3 zeigt ein solches weiteres Ausführungsbeispiel, bei dem die optisch aktiven Bereiche 210a, 210b, ... in Form von sechseckförmig ausgebildeten optisch aktiven Bereichen 210, 220, ... gebildet werden. In dem hier gezeigten Ausführungsbeispiel wird jedoch die integrierte Reihenverschaltung in vertikaler Richtung gebildet. Jeder optisch aktive Bereich weist wiederum eine Durchkontaktierung 170, die wiederum nahezu mittig in der sechseckigen Form angeordnet sind, und ein weitere Durchkontaktierung 171, die nahezu parallel zu einer Seitenkante der sechseckigen Form angeordnet ist, auf. Bei weiteren Ausführungsbeispielen können auch mehrere Durchkontaktierungen 170 pro optisch aktiven Bereich 210, 220, ... ausgebildet sein. Die Kontaktschichten 160 überbrücken wiederum benachbarte optisch aktive Bereiche 210, 220, ....

Ein Vorteil der gezeigten mittigen Anordnung der Durchkontaktierung 170 in den optisch aktiven Bereichen 210, 220, ... besteht beispielsweise darin, dass dadurch die Stromeinspeisung in die Grundelektrode 120 oder in dem jeweiligen Teil der Grundelektrode 120a,b, ... mittig erfolgt und somit eine möglichst gleichmäßige Stromeinspeisung in jedem der optisch aktiven Bereiche 210a, 210b, ... möglich ist. Alternativ können wie gesagt mehrere Durchkontaktierungen 170 pro optisch aktiven Bereich 210, 220 ausgebildet werden oder eine maximale Abmessung A der optisch aktiven Bereiche 210, 220, ... wird derart gewählt, dass jeder optisch aktive Bereich 210, 220, ... möglichst gleichmäßig Licht erzeugt. Beispielsweise kann die maximale Ausdehnung A derart gewählt werden, dass auch am Rand eines jeden optisch aktiven Bereichs 210, 220, ... noch so viel Licht erzeugt wird, dass sich eine homogene Leuchtdichte (keine dunklen Ränder) ergibt.

Da bei den in den Fig. 2 und 3 gezeigten Ausführungsbeispielen eine elektrische Verbindung der optisch aktiven Bereiche 210, 220, ... untereinander über die Kontaktschicht 160 erfolgt, die jeweils beispielsweise rechteckförmig ausgebildet ist, bedarf es keiner Kontaktierung entlang der Randbereiche der optisch aktive Bereiche 210, 220, .... Somit kann der Zwischenraum D zwischen benachbarten optisch aktiven Bereichen 210, 220, ... minimiert werden, wobei die Minimierung stets noch eine elektrische Isolierung der Teile der Grundelektrode 120a,b, ... und der Teile der Deckelektrode 140a,b, ... sicherstellt.

Ausführungsbeispiele der vorliegenden Erfindung ermöglichen somit eine integrierte Kontaktierung und eine einfache Serienverschaltung von OLED-Elementen mit optisch aktiven Bereichen 210, 220, ... in Kombination mit einer Verringerung der nicht aktiven Flächen.

In Ausführungsbeispielen können die Schichten die folgenden Dimensionierungen beispielhaft aufweisen. Als Substrat dient beispielsweise Glas mit einer Schichtdicke von ca. 0,5 - 2 mm. Die organische Schichtanordnung weist beispielsweise bis zu sieben Sublagen auf und kann eine Schichtdicke von ca. 100 bis 200 nm umfassen. Die Deckelektrode als metallische Kathode weist häufig Aluminium in einer Schichtdicke von ca. 100 bis 500 nm auf. Die ITO-Schicht kann beispielsweise einem Flächenwiderstand von ca. 10 bis 40 Ohm/Quadratfläche aufweisen, was Schichtdicken von ca. 90 - 150 nm entspricht. Außerdem weist die organische Schichtanordnung 130 komplementär dotierte organische Schichten, die einen pn-Übergang bilden, auf.

## Patentansprüche

1. OLED-Struktur mit:
einem Schichtstapel (110), der eine Grundelektrode (120), eine organische Schichtanordnung (130), eine Deckelektrode (140), eine Isolationsschicht (150) und eine Kontaktschicht (160) aufweist,
wobei die organische Schichtanordnung (130) zwischen der Grundelektrode (120) und der Deckelektrode (140) angeordnet ist und die Deckelektrode (140) zwischen der organischen Schichtanordnung (130) und der Kontaktschicht (160) angeordnet ist, und
wobei die Deckelektrode (140) und die Grundelektrode (120) strukturiert sind, um mehrere lateral benachbarte optisch aktive Bereiche (210) zu bilden und die Grundelektrode (120), die organische Schichtanordnung (130), die Deckelektrode (140) und die Kontaktschicht (160) durch Durchkontaktierungen (170, 171) derart verschaltet sind, dass
zumindest zwei optisch aktive Bereiche (210a, 210b) so in Serie geschaltet sind, dass ein Stromfluss durch die zumindest zwei optisch aktiven Bereiche (210a, 210b) in eine Richtung zwischen Grundelektrode (120) und Deckelektrode (140) weist,
wobei ein erster optisch aktiver Bereich (210a) durch einen ersten Teil der Grundelektrode (120a) und einen ersten Teil der Deckelektrode (140a), die beidseitig die organische Schichtanordnung (130) kontaktieren, gebildet ist und ein zweiter optisch aktiver Bereich durch einen zweiten Teil der Grundelektrode (120b) und einen zweiten Teil der Deckelektrode (140b), die die organische Schichtanordnung (130) beidseitig kontaktieren, gebildet ist, wobei ein lateraler Abstand (D) zwischen dem ersten optisch aktiven Bereich (210a) und dem zweiten optisch aktiven Bereich (210b) existiert,
die Kontaktschicht (160) die Grundelektrode (120) über eine der Durchkontaktierungen (170) lateral in einem Inneren des zweiten optisch aktiven Bereichs (210a, 210b) kontaktiert,
wobei die Isolationsschicht (150) teilweise zwischen der Kontaktschicht (160) und der Deckelektrode (140) angeordnet ist, so dass innerhalb des zweiten optisch aktiven Bereichs (210) die jeweilige Kontaktschicht (160) von der jeweiligen Deckelektrode (140) elektrisch isoliert ist,
wobei die Kontaktschicht (160) so strukturiert ist, dass ein erster Teil (160a) und ein zweiter Teil (160b) gebildet ist, **dadurch gekennzeichnet, dass** der Stromfluss zwischen den zumindest zwei optisch aktiven Bereichen (210a, 210b) durch die Kontaktschicht (160) verläuft, und dass die organische Schichtanordnung (130) komplementär dotierte organische Schichten, die einen pn-Übergang bilden, aufweist.

2. OLED-Struktur nach Anspruch 1, bei der die Isolationsschicht (150) die organische Schichtanordnung (130) seitlich schützt.

3. OLED-Struktur nach Anspruch 3, bei der die Durchkontaktierungen (170) Öffnungen (O1, O2) in der Deckelektrode (140) passieren und die Isolationsschicht (150) ausgebildet ist, um die Deckelektrode (140) und die Durchkontaktierung (170) innerhalb der Öffnungen (O1, O2) zu isolieren.

4. OLED-Struktur nach einem der vorhergehenden Ansprüche, bei der eine Kontaktierung der Deckelektrode (140) durch ein Kontaktpad (141), das an einer ersten oder letzten der in Serie geschalteten optisch aktiven Bereiche (210) ausgebildet ist, erfolgt.

5. OLED-Struktur nach einem der vorhergehenden Ansprüche, die ferner ein transparentes Substrat (105) aufweist, auf das die Grundelektrode (120) ausgebildet ist und die Grundelektrode (120) ein transparentes Material aufweist, so dass zumindest zwei optisch aktive Bereiche (210) auf dem Substrat (105) ausgebildet sind.

6. OLED-Struktur nach einem der vorhergehenden Ansprüche, bei der die Durchkontaktierungen (170) die Grundelektrode (120) von einer dem Substrat (105) abgewandten Seite kontaktieren.

7. OLED-Struktur nach einem der vorhergehenden Ansprüche, bei der in einem optisch aktiven Bereich (210) zumindest zwei Durchkontaktierungen (170) ausgebildet sind.

8. Leuchtelement mit:
einer Vielzahl von in Serie oder parallel geschalteten OLED-Strukturen nach einem der Ansprüche 1 bis 7, wobei das Leuchtelement eine Leuchtfläche bildet und die Leuchtfläche durch die mosaikförmig angeordneten optisch aktiven Bereiche (210, 220) gebildet ist.

9. Leuchtelement nach Anspruch 8, bei dem die optisch aktiven Bereiche (210, 220) viereckförmig oder sechseckförmig oder achteckförmig ausgebildet sind.

10. Verfahren zur Herstellung einer OLED-Struktur, mit folgenden Schritten:
Bereitstellen eines Substrats (105);
Bilden einer Grundelektrode (120);
Strukturieren der Grundelektrode (120), so dass ein erster Teil (120a) und ein zweiter Teil (120b) gebildet wird;
Bilden einer organischen Schichtanordnung (130) auf der Grundelektrode (120), so dass die organische Schichtanordnung (130) komplementär dotierte organische Schichten, die einen pn-Übergang bilden, aufweist;
Bilden einer Deckelektrode (140);
Strukturieren der Deckelektrode (140), so dass ein erster Teil (140a) und ein zweiter Teil (140b) gebildet wird, wobei der erste Teil der Deckelektrode (140a) auf der organischen Schichtanordnung (130) gegenüberliegend dem ersten Teil der Grundelektrode (120a) ausgebildet wird, so dass ein erster optisch aktiver Bereich (210a) gebildet wird, und wobei der zweite Teil der Deckelektrode (140b) auf der organischen Schichtanordnung (130) gegenüberliegend dem zweiten Teil der Grundelektrode (120b) ausgebildet wird, so dass ein zweiter optisch aktiver Bereich (210b) gebildet wird;
Bilden einer Isolationsschicht (150) auf der Deckelektrode (140);
Bilden einer Kontaktschicht (160) auf der Isolationsschicht (150) und Strukturieren der Kontaktschicht (160), so dass ein erster Teil (160a) und ein zweiter Teil (160b) gebildet wird;
Bilden von Durchkontaktierungen (170) zwischen dem ersten Teil der Kontaktschicht (160a) und dem ersten Teil der Grundelektrode (120a) und zwischen dem zweiten Teil der Kontaktschicht (160b) und dem zweiten Teil der Grundelektrode (120b);
Bilden einer weiteren Durchkontaktierung (171) zwischen dem zweiten Teil der Kontaktschicht (160b) und dem ersten Teil der Deckelektrode (140a), so dass eine Serienschaltung zwischen dem ersten optisch aktiven Bereich (210a) und dem zweiten optisch aktiven Bereich (210b) gebildet wird, bei der ein Stromfluss durch die zumindest zwei optisch aktiven Bereiche (210a, 210b) in eine Richtung zwischen Grundelektrode (120) und Deckelektrode (140) weist und der Stromfluss zwischen den zumindest zwei optisch aktiven Bereichen (210a, 210b) durch die Kontaktschicht (160) verläuft.

11. Verfahren nach Anspruch 10, bei dem die Durchkontaktierungen (170) mittig in den optisch aktiven Bereichen (210) ausgebildet werden.

12. Verfahren nach Anspruch 10 oder 11, bei dem das Bilden der Isolationsschicht (150) derart ausgeführt wird, dass die Isolationsschicht (150) die organische Schichtanordnung (130) lateral seitlich schützt.

## Claims

1. An OLED structure, comprising:
a layer stack (110) comprising a base electrode (120), an organic layer assembly (130), a cover electrode (140), an insulation layer (150) and a contact layer (160),
wherein the organic layer assembly (130) is arranged between the base electrode (120) and the cover electrode (140) and the cover electrode (140) is arranged between the organic layer assembly (130) and the contact layer (160), and
wherein the cover electrode (140) and the base electrode (120) are structured to form several laterally adjacent optically active areas (210) and the base electrode (120), the organic layer assembly (130), the cover electrode (140) and the contact layer (160) are interconnected by vias (170, 171) such that
at least two optically active areas (210a, 210b) are connected in series such that a current flow through the at least two optically active areas (210a, 210b) is directed into a direction between the base electrode (120) and the cover electrode (140),
wherein a first optically active area (210a) is formed by a first part of the base electrode (120a) and a first part of the cover electrode (140a) which contact the organic layer assembly (130) on both sides and a second optically active area is formed by a second part of the base electrode (120b) and a second part of the cover electrode (140b) which contact the organic layer assembly (130) on both sides, wherein a lateral distance (D) exists between the first optically active area (210a) and the second optically active area (210b),
the contact layer (160) contacts the base layer (120) through one of the vias (170) laterally in an interior of the second optically active area (210a, 210b),
wherein the insulation layer (150) is partially arranged between the contact layer (160) and the cover electrode (140), so that within the second optically active area (210) the respective contact layer (160) is electrically insulated from the respective cover electrode (140),
wherein the contact layer (160) is structured such that a first part (160a) and a second part (16b) are formed,
**characterized in that** the current flow between the at least two optically active areas (210a, 210b) passes through the contact layer (160), and **in that**
the organic layer assembly (130) comprises complementarily doped organic layers forming a pn junction.

2. The OLED structure according to claim 1, wherein the insulation layer (150) laterally protects the organic layer assembly (130).

3. The OLED structure according to claim 3, wherein the vias (170) pass openings (O1, 02) in the cover electrode (140) and the insulation layer (150) is implemented to insulate the cover electrode (140) and the via (170) within the openings (O1, 02).

4. The OLED structure according to any of the preceding claims, wherein the contacting of the cover electrode (140) is executed though a contact pad (141) formed at a first or last of the optically active areas (210) connected in series.

5. The OLED structure according to any of the preceding claims, further comprising a transparent substrate (105) on which the base electrode (120) is formed and wherein the base electrode (120) comprises a transparent material so that at least two optically active areas (210) are formed on the substrate (105).

6. The OLED structure according to any of the preceding claims, wherein the vias (170) contact the base electrode (120) from a side facing away from the substrate (105).

7. The OLED structure according to any of the preceding claims, wherein at least two vias (170) are implemented in an optically active area (210).

8. A luminous element, comprising:
a plurality of OLED structeres connected in series or in parallel according to any of claims 1 to 7,
wherein the luminous element forms a luminous surface and the luminous surface is formed by optically active areas (210, 220) arranged in a mosaic.

9. The luminous element according to claim 8, wherein the optically active areas (210, 220) are implemented in a quadrilateral, hexagonal or octagonal shape.

10. A method for manufacturing an OLED structure, comprising:
providing a substrate (105);
forming a base electrode (120);
structuring the base electrode (120) so that a first part (120a) and a second part (120b) are formed;
forming an organic layer assembly (130) on the base electrode (120) so that the organic layer assembly (130) comprises complementarily doped organic layers forming a pn junction;
forming a cover electrode (140);
structuring the cover electrode (140) so that a first part (140a) and a second part (140b) are formed, wherein the first part of the cover electrode (140a) is implemented on the organic layer assembly (130) opposite to the first part of the base electrode (120a), so that a first optically active area (210a) is formed, and wherein the second part of the cover electrode (140b) is formed on the organic layer assembly (130) opposite to the second part of the base electrode (120b) so that a second optically active area (210b) is formed;
forming an insulation layer (150) on the cover electrode (140);
forming a contact layer (160) on the insulation layer (150) and structuring the contact layer (160) so that a first part (150a) and a second part (160b) are formed;
forming vias (170) between the first part of the contact layer (160a) and the first part of the base electrode (120a) and between the second part of the contact layer (160b) and the second part of the base electrode (120b);
forming a further via (171) between the second part of the contact layer (160b) and the first part of the cover electrode (140a), so that a series connection between the first optically active area (210a) and the second optically active area (210b) is formed, wherein a current flow through the at least two optically active areas (210a, 210b) is directed into a direction between the base electrode (120) and the cover electrode (140) and the current flow between the at least two optically active areas (210a, 210b) passes through the contact layer (160).

11. The method according to claim 10, wherein the vias (170) are implemented in the center in the optically active areas (210).

12. The method according to claim 10 or 11, wherein forming the insulation layer (150) is executed such that the insulation layer (150) laterally protects the organic layer assembly (130).

## Revendications

1. Structure de diode électroluminescente organique (DELO), avec:
un empilement de couches (110) présentant une électrode de base (120), un aménagement de couche organique (130), une électrode de recouvrement (140), une couche d'isolation. (150) et une couche de contact (160),
dans laquelle l'aménagement de couche organique (130) est disposé entre l'électrode de base (120) et l'électrode de recouvrement (140) et l'électrode de recouvrement (140) est disposée entre l'aménagement de couche organique (130) et la couche de contact (160), et
dans laquelle l'électrode de recouvrement (140) et l'électrode de base (120) sont structurées de manière à former plusieurs zones optiquement actives adjacentes latéralement (210) et l'électrode de base (120), l'aménagement de couche organique (130), l'électrode de recouvrement (140) et la couche de contact (160) sont connectées par l'intermédiaire de trous d'interconnexion (170, 171) de sorte que
au moins deux zones optiquement actives (210a, 210b) sont connectées en série de sorte qu'un flux de courant dans les au moins deux zones optiquement actives (210a, 210b) soit orienté dans une direction entre l'électrode de base (120) et l'électrode de recouvrement (140),
dans laquelle une première zone optiquement active (210a) est formée par une première partie de l'électrode de base (120a) et une première partie de l'électrode de recouvrement (140a) qui entrent en contact de part et d'autre avec l'aménagement de couche organique (130), et une deuxième zone optiquement active est formée par une deuxième partie l'électrode de base (120b) et une deuxième partie de l'électrode de recouvrement (140b) qui entrent en contact de part et d'autre avec l'aménagement de couche organique (130), dans laquelle existe une distance latérale (D) entre la première zone optiquement active (210a) et la deuxième zone optiquement active (210b),
la couche de contact (160) entre en contact avec l'électrode de base (120) par l'intermédiaire de l'un des trous d'interconnexion (170) latéralement à l'intérieur de la deuxième zone optiquement active (210a, 210b),
dans laquelle la couche d'isolation (150) est disposée partiellement entre la couche de contact (160) et l'électrode de recouvrement (140), de sorte que, dans la deuxième zone optiquement active (210), la couche de contact respective (160) soit isolée électriquement de l'électrode de recouvrement respective (140),
dans laquelle la couche de contact (160) est structurée de sorte que soient formées une première partie (160a) et une deuxième partie (160b),
**caractérisée par le fait que** le flux de courant circule entre les au moins deux zones optiquement actives (210a, 210b) à travers la couche de contact (160), et
que l'aménagement de couche organique (130) présente des couches organiques dopées de manière complémentaire qui forment une transition pn.

2. Structure de DELO selon la revendication 1, dans laquelle la couche d'isolation (150) protège latéralement l'aménagement de couche organique (130).

3. Structure de DELO selon la revendication 3, dans laquelle les trous d'interconnexion (170) passent par des ouvertures (01, 02) dans l'électrode de recouvrement (140) et la couche d'isolation (150) est réalisée pour isoler l'électrode de recouvrement (140) et le trou d'interconnexion (170) à l'intérieur des ouvertures (01, 02).

4. Structure de DELO selon l'une des revendications précédentes, dans laquelle une mise en contact de l'électrode de recouvrement (140) a lieu par l'intermédiaire d'un plot de contact (141) qui est réalisé sur une première ou une dernière des zones optiquement actives connectées en série (210).

5. Structure de DELO selon l'une des revendications précédentes, présentant par ailleurs un substrat transparent (105) sur lequel est réalisée l'électrode de base (120), et l'électrode de base (120) présente un matériau transparent de sorte que soient formées au moins deux zones optiquement actives (210) sur le substrat (105).

6. Structure de DELO selon l'une des revendications précédentes, dans laquelle les trous d'interconnexion (170) entrent en contact avec l'électrode de base (120) d'un côté opposé au substrat (105).

7. Structure de DELO selon l'une des revendications précédentes, dans laquelle sont réalisés, dans une zone optiquement active (210), au moins deux trous d'interconnexion (170).

8. Elément lumineux, avec:
une pluralité de structures de DELO selon l'une des revendications 1 à 7 connectées en série ou en parallèle,
dans lequel l'élément lumineux constitue une surface lumineuse et la surface lumineuse est formée par les zones optiquement actives (220 210) disposées en forme de mosaïque.

9. Elément lumineux selon la revendication 8, dans lequel les zones optiquement actives (210, 220) sont réalisées de forme carrée ou hexagonale ou octogonale.

10. Procédé de fabrication d'une structure de DELO, aux étapes suivantes consistant à:
préparer un substrat (105);
former une électrode de base (120);
structurer l'électrode de base (120) de sorte que soient formées une première partie (120a) et une deuxième partie (120b);
former un aménagement de couche organique (130) sur l'électrode de base (120), de sorte que l'aménagement de couche organique (130) présente des couches organiques dopées de manière complémentaire constituant une transition pn:
former une électrode de recouvrement (140);
structurer l'électrode de recouvrement (140) de sorte que soient formées une première partie (140a) et une deuxième partie (140b), où la première partie de l'électrode de recouvrement (140a) est réalisée sur l'aménagement de couche organique (130) du côté opposé à la première partie de l'électrode de base (120a), de sorte que soit formée une première zone optiquement active (210a), et dans lequel la deuxième partie de l'électrode de recouvrement (140b) est réalisée sur l'aménagement de couche organique (130) du côté opposé à la deuxième partie de l'électrode de base (120b), de sorte que soit formée une deuxième zone optiquement active (210b);
former une couche d'isolation (150) sur l'électrode de recouvrement (140);
former une couche de contact (160) sur la couche d'isolation (150) et structurer la couche de contact (160), de sorte que soient formées une première partie (160a) et une deuxième partie (160b);
former des trous d'interconnexion (170) entre la première partie de la couche de contact (160a) et la première partie de l'électrode de base (120a) et entre la deuxième partie de la couche de contact (160b) et la deuxième partie de l'électrode de base (120b);
former un autre trou d'interconnexion (171) entre la deuxième partie de la couche de contact (160b) et la première partie de l'électrode de recouvrement (140a), de sorte que soit formé un circuit en série entre la première zone optiquement active (210a) et la deuxième zone optiquement active (210b), dans lequel un flux de courant est orienté à travers les au moins deux zones optiquement actives (210a, 210b) dans une direction entre l'électrode de base (120) et l'électrode de recouvrement (140), et le flux de courant circule entre les au moins deux zones optiquement actives (210a, 210b) à travers la couche de contact (160).

11. Procédé selon la revendication 10, dans lequel les trous d'interconnexion (170) sont réalisés au centre dans les zones optiquement actives (210).

12. Procédé selon la revendication 10 ou 11, dans lequel la formation de la couche d'isolation (150) est réalisée de sorte que la couche d'isolation (150) protège l'aménagement de couche organique (130) du côté latéral.
